# EUROPÄISCHE PATENTSCHRIFT

(11) **EP 2 238 194 B1**
(45) Veröffentlichungstag und Bekanntmachung des Hinweises auf die Patenterteilung: **07.02.2018**
(21) Anmeldenummer: 08871431.6
(22) Anmeldetag: 18.12.2008
(51) Int. Cl.: C08G 61/12, H01B 1/12, H01L 51/00

(54) **VERFAHREN ZUR HERSTELLUNG VON LEITFÄHIGEN POLYMEREN**
METHOD FOR THE PRODUCTION OF CONDUCTIVE<I></I>POLYMERS
PROCÉDÉ DE FABRICATION DE POLYMÈRES CONDUCTEURS

(30) Priorität: 22.01.2008 DE 102008005568
(43) Veröffentlichungstag der Anmeldung: 13.10.2010
(73) Patentinhaber: Heraeus Deutschland GmbH & Co. KG, 63450 Hanau (DE)
(72) Erfinder: JONAS, Friedrich, 52066 Aachen (DE); GUNTERMANN, Udo, 47800 Krefeld (DE)
(74) Vertreter: Herzog, Fiesser & Partner Patentanwälte PartG mbB
(86) Internationale Anmeldenummer: PCT/EP2008/067884
(87) Internationale Veröffentlichungsnummer: WO 2009/092503

(56) Entgegenhaltungen:
- EP-A- 0 440 957
- DE-A1- 10 220 684
- LI W ET AL: "Application of ultrasonic irradiation in preparing conducting polymer as active materials for supercapacitor" MATERIALS LETTERS, NORTH HOLLAND PUBLISHING COMPANY. AMSTERDAM, NL, Bd. 59, Nr. 7, 1. März 2005 (2005-03-01), Seiten 800-803, XP025257209 ISSN: 0167-577X [gefunden am 2005-03-01]
- DE AZEVEDO W M ET AL: "Conductive polymer preparation under extreme or non-classical conditions" JOURNAL OF MATERIALS SCIENCE, KLUWER ACADEMIC PUBLISHERS, BO, Bd. 43, Nr. 4, 12. Dezember 2007 (2007-12-12), Seiten 1400-1405, XP019575164 ISSN: 1573-4803

## Beschreibung

Die Erfindung betrifft ein neues Verfahren zur Herstellung von leitfähigen Polymeren in Gegenwart von Polyanionen, mit diesem Verfahren hergestellte wässrige oder nicht-wässrige Dispersionen oder Lösungen sowie deren Verwendung.

Leitfähige Polymere gewinnen zunehmend an wirtschaftlicher Bedeutung, da Polymere gegenüber Metallen Vorteile bezüglich der Verarbeitbarkeit, des Gewichts und der gezielten Einstellung von Eigenschaften durch chemische Modifikation haben. Beispiele für bekannte π-konjugierte Polymere sind Polypyrrole, Polythiophene, Polyaniline, Polyacetylene, Polyphenylene und Poly(p-phenylen-vinylene). Schichten aus leitfähigen Polymeren werden technisch vielfältig eingesetzt, z.B. als polymere Gegenelektrode in Kondensatoren, als antistatische Beschichtung oder zur Durchkontakticrung von elektronischen Leiterplatten.

Die Herstellung leitfähiger Polymere erfolgt chemisch oder elektrochemisch oxidativ aus monomeren Vorstufen, wie z. B. gegebenenfalls substituierten Thiophenen, Pyrrolen und Anilinen und deren jeweiligen gegebenenfalls oligomeren Derivaten. Insbesondere die chemisch oxidative Polymerisation ist weit verbreitet, da sie technisch einfach in einem flüssigen Medium bzw. auf vielfältigen Substraten zu realisieren ist.

Ein besonders wichtiges und technisch genutztes Polythiophen ist das Poly(ethylen-3,4-dioxythiophen) (PEDOT oder PEDT), das durch chemische Polymerisation von Ethylen-3,4-dioxythiophen (EDOT oder EDT) hergestellt wird und das in seiner oxidierten Form sehr hohe Leitfähigkeiten aufweist und beispielsweise in der EP 339 340 A2 beschrieben ist. Eine Übersicht über zahlreiche Poly(alkylen-3,4-dioxythiophen)-Derivate, insbesondere Poly(ethylen-3,4-dioxythiophen)-Derivate, deren Monomerbausteine, Synthesen und Anwendungen geben L. Groenendaal, F. Jonas, D. Freitag, H. Pielartzik & J. R. Reynolds, Adv. Mater. 12, (2000) S. 481 - 494.

Besondere technische Bedeutung haben Dispersionen von PEDOT mit Polystyrolsulfonsäure (PSS) erlangt, wie sie beispielsweise in der EP 0440 957 offenbart sind. In der WO 2007/031206 ist die Herstellung niedrig viskoser PEDOT/PSS Dispersionen zur Innenimprägnierung von Kondensatoren beschrieben. Das dort beschriebene Herstellungsverfahren hat den Nachteil langer Reaktionszeiten, und dass nach Herstellung der Dispersion zusätzliche Verfahrensschritte zur Senkung der Viskosität der Dispersion, z.B. durch Hochdruckhomogenisierung, erforderlich sind.

Es bestand somit weiterhin Bedarf an einem Verfahren zur Herstellung leitfähiger Polymere, welche eine niedrige Viskosität aufweisen.

Die Aufgabe der vorliegenden Erfindung lag also darin, ein solches Verfahren bereitzustellen.

Überraschenderweise wurde jetzt gefunden, dass niedrig viskose leitfähige Polymere - ohne zusätzliche Verfahrensschritte - in kurzen Reaktionszeiten hergestellt werden können, wenn die Herstellung unter Ultraschall-Beschallung erfolgt.

Gegenstand der Erfindung ist daher ein Verfahren zur Herstellung einer wässrigen oder nicht-wässrigen Dispersion oder Lösung enthaltend wenigstens ein leitfähiges Polymer und wenigstens ein Polyanion, dadurch gekennzeichnet, dass die Polymerisation unter Ultraschall-Beschallung durchgeführt wird.

Leitfähige Polymere können im Rahmen der Erfindung gegebenenfalls substituierte Polypyrrole, gegebenenfalls substituiertes Polyaniline oder gegebenenfalls substituierte Polythiophene sein. Es kann auch sein, dass Mischungen aus zwei oder mehreren dieser leitfähigen Polymere mit dem erfindungsgemäßen Verfahren hergestellt werden.

Besonders bevorzugte leitfähige Polymere sind gegebenenfalls substituierte Polythiophene enthaltend wiederkehrende Einheiten der allgemeinen Formel (I), 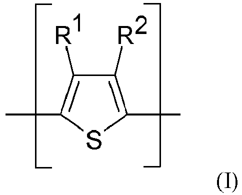 wobei
- R¹ und R²: unabhängig voneinander jeweils für H, einen gegebenenfalls substituierten C₁-C₁₈-Alkylrest oder einen gegebenenfalls substituierten C₁-C₁₈-Alkoxyrest, oder
- R¹ und R²: zusammen für einen gegebenenfalls substituierten C₁-C₈-Alkylenrest, worin ein oder mehrere C-Atom(e) durch ein oder mehrere gleiche oder unterschiedliche Heteroatome ausgewählt aus O oder S ersetzt sein können, bevorzugt einen C₁-C₈-Dioxyalkylenrest, einen gegebenenfalls substituierten C₁-C₈-Oxythiaalkylenrest oder einen gegebenenfalls substituierten C₁-C₈-Dithiaalkylenrest, oder für einen gegebenenfalls substituierten C₁-C₈-Alkylidenrest, worin gegebenenfalls wenigstens ein C-Atom durch ein Heteroatom ausgewählt aus O oder S ersetzt sein kann, stehen.

In bevorzugten Ausführungsformen sind Polythiophene enthaltend wiederkehrende Einheiten der allgemeinen Formel (I) solche enthaltend wiederkehrende Einheiten der allgemeinen Formel (I-a) und/oder der allgemeinen Formel (I-b) 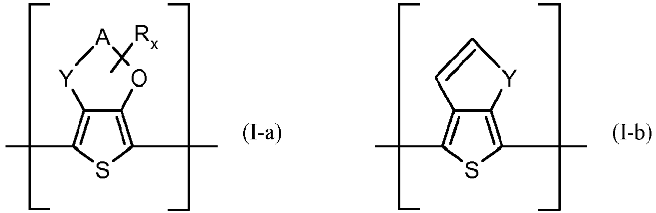 worin
- A: für einen gegebenenfalls substituierten C₁-C₅-Alkylenrest, bevorzugt für einen gegebenenfalls substituierten C₂-C₃-Alkylenrest steht,
- Y: für O oder S steht,
- R: für einen linearen oder verzweigten, gegebenenfalls substituierten C₁-C₁₈-Alkylrest, bevorzugt linearen oder verzweigten, gegebenenfalls substituierten C₁-C₁₄-Alkylrest, einen gegebenenfalls substituierten C₅-C₁₂-Cycloalkylrest, einen gegebenenfalls substituierten C₆-C₁₄-Arylrest, einen gegebenenfalls substituierten C₇C₁₈-Aralkylrest, einen gegebenenfalls substituierten C₁-C₄-Hydroxyalkylrest oder einen Hydroxylrest steht,
- x: für eine ganze Zahl von 0 bis 8, bevorzugt für 0, 1 oder 2, besonders bevorzugt für 0 oder 1, steht, und
für den Fall, dass mehrere Reste R an A gebunden sind, diese gleich oder unterschiedlich sein können.

Die allgemeine Formeln (I-a) ist so zu verstehen, dass der Substituent R x-mal an den Alkylenrest A gebunden sein kann.

In weiteren bevorzugten Ausführungsformen sind Polythiophene enthaltend wiederkehrende Einheiten der allgemeinen Formel (I) solche enthaltend wiederkehrende Einheiten der allgemeinen Formel (I-aa) und/oder der allgemeinen Formel (I-ab) 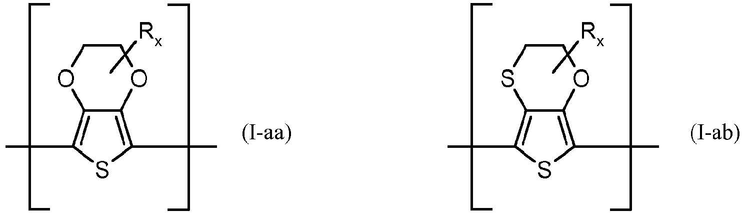 worin
R und x die oben genannte Bedeutung haben.

In noch weiteren bevorzugten Ausführungsformen sind Polythiophene enthaltend wiederkehrende Einheiten der allgemeinen Formel (I) solche enthaltend Polythiophene der allgemeinen Formel (I-aaa) und/oder der allgemeinen Formel (I-aba)

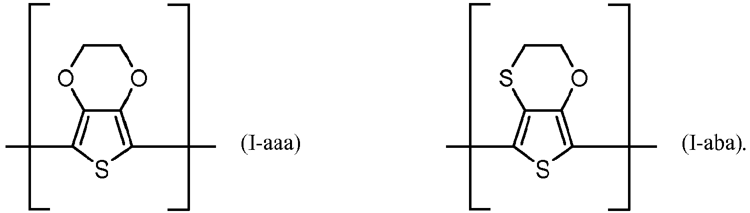

Unter dem Präfix Poly- ist im Rahmen der Erfindung zu verstehen, dass mehr als eine gleiche oder verschiedene wiederkehrende Einheit im Polythiophen enthalten ist. Die Polythiophene enthalten insgesamt n wiederkehrende Einheiten der allgemeinen Formel (I), wobei n eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene enthaltend jeweils gleiche wiederkehrende Einheiten der allgemeinen Formel (I).

An den Endgruppen tragen die Polythiophene bevorzugt jeweils H.

In besonders bevorzugten Ausführungsformen ist das Polythiophen mit wiederkehrenden Einheiten der allgemeinen Formel (I) Poly(3,4-ethylendioxythiophen), Poly(3,4-ethylenoxythiathiophen) oder Poly(thieno[3,4-b]thiophen, d.h. ein Homopolythiophen aus wiederkehrenden Einheiten der Formel (I-aaa), (I-aba) oder (I-b), wobei bei der Formel (I-b) Y=S ist.

In weiteren besonders bevorzugten Ausführungsformen ist das Polythiophen mit wiederkehrenden Einheiten der allgemeinen Formel (I) ein Copolymer aus wiederkehrenden Einheiten der Formel (I-aaa) und (I-aba), (I-aaa) und (I-b), (I-aba) und (I-b) oder (I-aaa), (I-aba) und (I-b), wobei Copolymere aus wiederkehrenden Einheiten der Formel (I-aaa) und (I-aba) sowie (I-aaa) und (I-b) bevorzugt sind.

C₁-C₅-Alkylenreste A sind im Rahmen der Erfindung Methylen, Ethylen, n-Propylen, n-Butylen oder n-Pentylen, C₁-C₈-Alkylenreste darüber hinaus n-Hexylen, n-Heptylen und n-Oktylen. C₁-C₈-Alkylidenreste sind im Rahmen der Erfindung vorangehend aufgeführte C₁-C₈-Alkylenreste enthaltend wenigstens eine Doppelbindung. C₁-C₈-Dioxyalkylenreste, C₁-C₈-Oxythiaalkylenreste und C₁-C₈-Dithiaalkylenreste stehen im Rahmen der Erfindung für die den vorangehend aufgeführten C₁-C₈-Alkylenreste entsprechenden C₁-C₈-Dioxyalkylenreste, C₁-C₈-Oxythiaalkylenreste und C₁-C₈-Dithiaalkylenreste. C₁-C₁₈-Alkyl steht im Rahmen der Erfindung für lineare oder verzweigte C₁-C₁₈-Alkylreste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste, wie Cyclopentyl, Cyclohexyl, Cycloheptyl, Cyclooctyl, Cyclononyl oder Cyclodecyl, C₆-C₁₄-Aryl für C₆-C₁₄-Arylreste wie Phenyl oder Naphthyl, und C₇-C₁₈-Aralkyl für C₇-C₁₈-Aralkylreste wie beispielsweise Benzyl, o-, m-, p-Tolyl, 2,3-, 2,4-, 2,5-, 2,6-, 3,4-, 3,5-Xylyl oder Mesityl. C₁-C₁₈-Alkoxyreste stehen im Rahmen der Erfindung für die den vorangehend aufgeführten C₁-C₁₈-Alkylresten entsprechenden Alkoxyreste. Die vorangehende Aufzählung dient der beispielhaften Erläuterung der Erfindung und ist nicht als abschließend zu betrachten.

Als gegebenenfalls weitere Substituenten der vorangehenden Reste kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen.

Die oben genannten wässrigen Dispersionen oder Lösungen, bevorzugt enthaltend 3,4-Polyalkylendioxythiophene, können beispielsweise in Analogie zu dem in der EP 440 957 beschriebenen Verfahren unter Ultraschall-Beschallung hergestellt werden. Hierzu kann z.B. ein Ultraschallfinger in das Reaktionsmedium gehängt werden. Es ist aber auch möglich, das Reaktionsmedium durch eine Ultaschall-Durchflusszelle zu pumpen. Hier kann der Energieeintrag zwischen 10 und 1000 Watt/Liter (W/l) Reaktionsmedium, bevorzugt zwischen 20 und 500 W/l Reaktionsmedium, besonders bevorzugt zwischen 20 und 200 W/l Reaktionsmedium, liegen.

Für das erfindungsgemäße Verfahren wird eine Ultraschallfrequenz zwischen 20 und 200 kHz, bevorzugt zwischen 20 und 100 kHz, besonders bevorzugt zwischen 22 und 50 kHz, verwendet. Als Oxidationsmittel und Lösungsmittel kommen ebenfalls die in EP 440 957 aufgeführten in Frage.

Im Anschluss an die Herstellung der erfindungsgemäßen Dispersionen werden die Dispersionen, bevorzugt zur Entfernung anorganischer Salze, mit basischen und sauren Ionenaustauschern behandelt.

Unter einer wässrigen Dispersion oder Lösung wird im Rahmen dieser Erfindung eine Dispersion oder Lösung verstanden, die mindestens 50% Gewichtsprozent (Gew.-%) an Wasser, bevorzugt mindestens 90 Gew.-% an Wasser, enthält, und gegebenenfalls Lösungsmittel enthält, welche mit Wasser - zumindest teilweise - mischbar sind, wie Alkohole, z.B. Methanol, Ethanol, n-Propanol, Isopropanol, Butanol oder Octanol, Glykole oder Glykolether, z.B. Ethylenglykol, Diethylenglykol, Propan-1,2-diol, Propan-1,3-diol oder Dipropylenglykoldimethylether oder Ketone wie beispielsweise Aceton oder Methylethylketon. In der wässrigen Dispersion oder Lösung kann der Feststoffgehalt an gegebenenfalls substituierten Polythiophenen, insbesondere an gegebenenfalls substituierten Polythiophenen enthaltend wiederkehrende Einheiten der allgemeinen Formel (I), zwischen 0,05 und 4,0 Gew.-%, bevorzugt zwischen 0,1 und 2,0 Gew.-%, liegen.

Im Rahmen der Erfindung versteht man unter einer niedrig-viskosen Dispersion eine Dispersion, welche bei einem Feststoffgehalt an gegebenenfalls substituierten Polythiophenen von 1,0 - 1,5 Gew.-% eine Viskosität bei 20°C zwischen 1 und 100 mPas, bevorzugt zwischen 4 und 80 mPas, besonders bevorzugt zwischen 6 und 60 mPas, jeweils gemessen mit einem Rheometer bei einer Scherrate von 100/sec, aufweist.

Verfahren zur Herstellung der monomeren Vorstufen für die Herstellung der Polythiophene der allgemeinen Formel (I) sowie deren Derivaten sind dem Fachmann bekannt und beispielsweise in L. Groenendaal, F. Jonas, D. Freitag, H. Pielartzik & J. R. Reynolds, Adv. Mater. 12 (2000) 481 - 494 und darin zitierter Literatur beschrieben.

Unter Derivaten der vorangehend aufgeführten Thiophene werden im Sinne der Erfindung beispielsweise Dimere oder Trimere dieser Thiophene verstanden. Es sind auch höhermolekulare Derivate, d.h. Tetramere, Pentamere etc. der monomeren Vorstufen als Derivate möglich. Die Derivate können sowohl aus gleichen wie unterschiedlichen Monomereinheiten aufgebaut sein und in reiner Form sowie im Gemisch untereinander und/oder mit den vorangehend genannten Thiophenen eingesetzt werden. Auch oxidierte oder reduzierte Formen dieser Thiophene und Thiophenderivate sind im Sinne der Erfindung von dem Begriff Thiophene und Thiophenderivate umfasst, sofern bei ihrer Polymerisation die gleichen leitfähigen Polymeren entstehen wie bei den vorangehend aufgeführten Thiophenen und Thiophenderivaten.

Die Thiophene können gegebenenfalls in Form von Lösungen eingesetzt werden. Als geeignete Lösungsmittel seien vor allem folgende unter den Reaktionsbedingungen inerte organische Lösungsmittel genannt: aliphatische Alkohole wie Methanol, Ethanol, i-Propanol und Butanol; aliphatische Ketone wie Aceton und Methylethylketon; aliphatische Carbonsäureester wie Essigsäureethylester und Essigsäurebutylester; aromatische Kohlenwasserstoffe wie Toluol und Xylol; aliphatische Kohlenwasserstoffe wie Hexan, Heptan und Cyclohexan; Chlorkohlenwasserstoffe wie Dichlormethan und Dichlorethan; aliphatische Nitrile wie Acetonitril, aliphatische Sulfoxide und Sulfone wie Dimethylsulfoxid und Sulfolan; aliphatische Carbonsäureamide wie Mcthylacctamid, Dimethylacetamid und Dimethylformamid; aliphatische und araliphatische Ether wie Diethylether und Anisol. Weiterhin kann auch Wasser oder ein Gemisch aus Wasser mit den vorgenannten organischen Lösungsmitteln als Lösungsmittel verwendet werden. Bevorzugte Lösungsmittel sind Alkohole und Wasser sowie Mischungen enthaltend Alkohole oder Wasser bzw. Mischungen aus Alkoholen und Wasser. Thiophene, die unter den Oxidationsbedingungen flüssig sind, können auch in Abwesenheit von Lösungsmitteln polymerisiert werden.

Die wässrige Dispersion oder Lösung kann zusätzlich wenigstens ein polymeres Bindemittel enthalten. Geeignete Bindemittel sind polymere, organische Binder, beispielsweise Polyvinylalkohole, Polyvinylpyrrolidone, Polyvinylchloride, Polyvinylacetate, Polyvinylbutyrate, Polyacrylsäureester, Polyacrylsäureamide, Polymethacrylsäureester, Polymethacryl-säureamide, Polyacrylnitrile, Styrol/Acrylsäureester-, Vinylacetat/Acrylsäureester- und Ethylen/Vinylacetat-Copolymerisate, Polybutadiene, Polyisoprene, Polystyrole, Polyether, Polyester, Polycarbonate, Polyurethane, Polyamide, Polyimide, Polysulfone, Melamin-Formaldehyharze, Epoxidharze, Siliconharze oder Cellulosen. Der Feststoffgehalt an polymerem Bindemittel liegt zwischen 0 und 5,0 Gew. -%, bevorzugt zwischen 0 und 2,0 Gew.- %.

Die Dispersion oder Lösung kann zusätzlich Haftvermittler, wie beispielsweise organofunktionelle Silane bzw. deren Hydrolysate, z.B. 3-Glycidoxypropyltrialkoxysilan, 3-Aminopropyltriethoxysilan, 3-Mercaptopropyltrimethoxysilan, 3-Metacryloxypropyltrimethoxysilan, Vinyltrimethoxysilan oder Octyltriethoxysilan, enthalten.

Im Rahmen der Erfindung können die nicht-wässrigen Dispersionen oder Lösungen enthaltend wenigstens ein leitfähiges Polymer, bevorzugt gegebenenfalls substituierte Polythiophene, und wenigstens ein Polyanion in Analogie zu dem in der EP 1 373 356 offenbarten Verfahren hergestellt werden:
In einem ersten Verfahrensschritt werden wässrige Dispersionen oder Lösungen gemäß dem erfindungsgemäßen Verfahren hergestellt; in einem zweiten Verfahrensschritt wird zu dieser wässrigen Dispersion oder Lösung ein mit Wasser mischbares Lösungsmittel oder ein mit Wasser mischbares Lösungsmittelgemisch gegeben und dann wird das Wasser wenigstens zum Teil aus den resutierenden Mischungen entfernt und gegebenenfalls mit organischen Lösungsmitteln verdünnt. Als Lösungsmittel kommen hierbei amidische Lösungsmittel wie beispielsweise Formamid, N-methylacetamid, N, N-Dimethylacetamid, N-Methylpyrroliodn, N-Methylcaprolactam oder N-Methylformamid, Alkohole und Ether wie beispielsweise Ethylenglykol, Glycerin, Ethylenglycoldimethylether, Ethylenglycolmonomethylether, Ethylenglycolmonobutylether oder Dioxan in Frage. Bevorzugt werden amidische Lösungsmittel und Lösungsmittel, die einen Siedepunkt von über 100°C bei Normaldruck besitzen und wassermischbare Lösungsmittel oder wassermischbare Lösungsmittelgemische, die mit Wasser ein Azeotrop bilden. Die Entfernung des Wassers kann beispielsweise durch Membranverfahren wie Ultrafiltration oder durch Destillation erfolgen. Falls eine Verdünnung mit organischen Lösungsmittel erfolgt, sind als Lösungsmittel die oben erwähnten Lösungsmittel und aliphatische Alkohole wie zum Beispiel Methanol, Ethanol, n-Propanol, isoPropanol, n-Butanol, iso-Butanol, tert-Butanol, Amylalkohol, iso-Amylalkohol, Neopentylakohol, Aliphatische Ketone wie beispielsweise Aceton, Methylethylketon, Methylisobutylketon, Methyl-tert.-butylketon, Ethyler wie zum Beispiel Tetrahydrofuran, Methyl-tert.-butylether, Ester aliphatischer und aromatischer Carbonsäuren wie zum Beispiel Essigsäureethylester, Essigsäurebutylester, Glycolmonomethyletheracetat, Phtalsäurebutylester oder aliphatische und aromatische Kohlenwassserstoffe wie Pentan, Hexan, Cyclohexan, Octan, iso-Octan, Decan, Toluol, o-Xylol, m-Xylol oder p-Xylol.

Die leitfähigen Polymere, insbesondere die Polythiophene, können neutral oder kationisch sein. In bevorzugten Ausführungsformen sind sie kationisch, wobei sich "kationisch" nur auf die Ladungen bezieht, die auf der Polythiophenhauptkette sitzen. Je nach Substituent an den Resten R können die Polythiophene positive und negative Ladungen in der Struktureinheit tragen, wobei sich die positiven Ladungen auf der Polythiophenhauptkette und die negativen Ladungen gegebenenfalls an den durch Sulfonat- oder Carboxylatgruppen substituierten Resten R befinden. Dabei können die positiven Ladungen der Polythiophenhauptkette zum Teil oder vollständig durch die gegebenenfalls vorhandenen anionischen Gruppen an den Resten R abgesättigt werden. Insgesamt betrachtet können die Polythiophene in diesen Fällen kationisch, neutral oder sogar anionisch sein. Dennoch werden sie im Rahmen der Erfindung alle als kationische Polythiophene betrachtet, da die positiven Ladungen auf der Polythiophenhauptkette maßgeblich sind. Die positiven Ladungen sind in den Formeln nicht dargestellt, da ihre genaue Zahl und Position nicht einwandfrei feststellbar sind. Die Anzahl der positiven Ladungen beträgt jedoch mindestens 1 und höchstens n, wobei n die Gesamtanzahl aller wiederkehrenden Einheiten (gleicher oder unterschiedlicher) innerhalb des Polythiophens ist.

Zur Kompensation der positiven Ladung, soweit dies nicht bereits durch die gegebenenfalls Sulfonat- oder Carboxylat-substituierten und somit negativ geladenen Reste R erfolgt, benötigen die kationischen Polythiophene Anionen als Gegenionen.

Als Gegenionen kommen monomere oder polymere Anionen, letztere im Folgenden auch als Polyanionen bezeichnet, in Frage.

Als monomere Anionen dienen beispielsweise solche von C₁-C₂₀-Alkansulfonsäuren, wie der Methan-, Ethan-, Propan-, Butan- oder höheren Sulfonsäuren, wie der Dodecansulfonsäure, von aliphatischen Perfluorsulfonsäuren, wie der Trifluormethansulfonsäure, der Perfluorbutansulfonsäure oder der Perfluoroctansulfonsäure, von aliphatischen C₁-C₂₀-Carbonsäuren wie der 2-Ethylhexylcarbonsäure, von aliphatischen Perfluorcarbonsäuren, wie der Trifluoressigsäure oder der Perfluoroctansäure, und von aromatischen, gegebenenfalls durch C₁-C₂₀-Alkylgruppen substituierten Sulfonsäuren wie der Benzolsulfonsäure, o-Toluolsulfonsäure, p-Toluolsulfonsäure, Dodecylbenzolsulfonsäure, Dinonylnaphthalinsulfonsäure oder Dinonylnaphthalindisulfonsäure, und von Cycloalkansulfonsäuren wie Camphersulfonsäure oder Tetrafluoroborate, Hexafluorophosphate, Perchlorate, Hexafluoroantimonate, Hexafluoroarsenate oder Hexachloroantimonate.

Besonders bevorzugt sind die Anionen der p-Toluolsulfonsäure, Methansulfonsäure oder Camphersulfonsäure.

Es können auch Anionen des verwendeten Oxidationsmittels oder aus diesem nach der Reduktion gebildete Anionen als Gegenionen dienen, so dass eine Zugabe zusätzlicher Gegenionen nicht zwingend erforderlich ist.

Bevorzugte polymere Anionen sind beispielsweise Anionen polymerer Carbonsäuren, wie Polyacrylsäuren, Polymethacrylsäuren oder Polymaleinsäuren, oder polymerer Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein. Diese können beispielsweise auch SO₃⁻M⁺- oder COO⁻M⁺-Gruppen enthaltende teilfluorierte oder perfluorierte Polymere sein, wobei M⁺ beispielsweise für, Li⁺, Na⁺, K⁺, Rb⁺, Cs⁺ oder NH₄⁺, bevorzugt für H⁺, Na⁺ oder K⁺ steht.

Besonders bevorzugt als polymeres Anion ist das Anion der Polystyrolsulfonsäure (PSS) als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Kationische Polythiophene, die zur Ladungskompensation Anionen als Gegenionen enthalten, werden in der Fachwelt auch oft als Polythiophen/(Poly-)Anion-Komplexe bezeichnet.

Die Polymerisation wird bevorzugt bei einer Temperatur in einem Bereich von 0 - 35°C, besonders bevorzugt bei einer Temperatur in einem Bereich von 5 - 25 °C, und ganz besonders bevorzugt bei einer Temperatur in einem Bereich von 10 - 20°C, durchgeführt.

Die Polymerisationszeit liegt zwischen 0,1 und 48 Stunden (h), bevorzugt zwischen 0,5 und 24 h, besonders bevorzugt zwischen 1,0 und 10 h.

Ein bevorzugtes erfindungsgemäßes Verfahren zur Herstellung einer wässrigen oder nicht-wässrigcn Dispersion oder Lösung enthaltend wenigstens ein leitfähiges Polymer und wenigstens ein Polyanion ist dadurch gekennzeichnet, dass das Verfahren folgende Schritte umfasst:
1) Zugeben wenigstens eines Oxidationsmittels erst dann, wenn unter Zuhilfenahme von Inertgas das Reaktionsmedium inertisiert ist,
2) Durchführen der Polymerisation unter Ultraschall-Beschallung.

Im Rahmen der Erfindung gilt das Reaktionsmedium als inertisiert, wenn das Inertgas für mindestens 5 Minuten, bevorzugt mindestens 20 Minuten durch das Reaktionsmedium geleitet wurde. Als Inertgas eignen sich beispielsweise Argon, Helium oder Stickstoff. Das Reaktionsmedium gilt auch als inertisiert, wenn der Innendruck des Reaktionsgefäßes mindestens einmal abgesenkt wurde, und der Innendruck anschließend durch Zugabe von Inertgas erhöht wurde.

In der noch nicht veröffentlichten DE 10 2007 041722.7 wird die Herstellung von leitfähigen Polymeren unter reduziertem Druck beschrieben.

Ein weiteres bevorzugtes erfindungsgemäßes Verfahren zur Herstellung einer wässrigen oder nicht-wässrigen Dispersion oder Lösung enthaltend wenigstens ein leitfähiges Polymer und wenigstens ein Polyanion ist dadurch gekennzeichnet, dass das Verfahren folgende Schritte umfasst:
Durchführen der Polymerisation bei einem Druck, welcher unter dem Atmosphärendruck liegt und unter Ultraschall-Beschallung.

Hierbei wird die Polymerisation bevorzugt bei einem Druck durchgeführt, welcher unter 800 hPa, bevorzugt unter 200 hPa, ganz besonders bevorzugt unter 50 hPa, liegt.

Um die Leitfähigkeit der wässrigen oder nicht-wässrigen Dispersionen oder Lösungen zu steigern, können im Rahmen der Erfindung leitfähigkeitssteigernde Mittel wie Dimethylsulfoxid dazugegeben werden. Aber auch andere leitfähigkeitssteigernde Mittel, wie in der EP 0686662 oder von O-uyang et al., Polymer, 45 (2004), S. 8443 - 8450 offenbart, können im Rahmen der Erfindung als leitfähigkeitssteigernde Mittel verwendet werden. Die erreichbaren Leitfähigkeiten können bis zu 2000 S/cm, bevorzugt 1000 S/cm, betragen,

Ein weiterer Gegenstand der vorliegenden Erfindung ist die Verwendung einer wässrigen oder nicht-wässrigen Lösung oder Dispersion, die nach dem erfindungsgemäßen Verfahren hergestellt wird, zur Herstellung leitfähiger Beschichtung, dadurch gakennzeichnet, dass die Leitfähigkeiten der so hergestellten Beschichtungen mindestens 150 S/cm, bevorzugt mindestens 200 S/cm betragen.

Die folgenden Beispiele dienen lediglich der beispielhaften Erläuterung der Erfindung.

### Beispiele:

### Vergleichsbeispiel:

In einem mit Kühlmantel versehenen 200 ml Glasgefäß wurden 79,74 g Wasser und 0,39 g 3,4-Ethylendioxythiophen vorgelegt. Die Emulsion wurde unter Wasserkühlung auf einem Magnetrührer gerührt. Anschließend wurden 15,03 g einer wässrigen Polystyrolsulfonsäure mit einem mittleren Molekulargewicht M_{w} von 70000 g/mol und einem Feststoffgehalt von 5 %, 0,22 g Eisen(III)sulfat gelöst in 3,87 g Wasser, und 0,76 g Natriumperoxodisulfat zugegeben. Die Reaktionsmischung wurde anschließend weitere 3 Stunden (h) unter Kühlung auf dem Magnetrührer gerührt, wobei die Dispersion hochviskos wurde. Nach Abschalten des Magnetrührers gelierte die Lösung.

### Erfindungsgemäßes Beispiel 1:

In einem mit Kühlmantel versehenen 200 ml Glasgefäß wurden 79,74 g Wasser und 0,39 g 3,4-Ethylendioxythiophen vorgelegt. Die Emulsion wurde unter Wasserkühlung von Außen 15 Minuten (min.) mit einem Ultraschallfinger (24 khz, 100 W Leistung Ultraschallprozessor der Fa. Hielscher UP 200 S) emulgiert. Anschließend wurden 15,03 g einer wässrigen Polystyrolsulfonsäure mit einem mittleren Molekulargewicht M_{w} von 70000 g/mol und einem Feststoffgehalt von 5 % , 0,22 g Eiscn(III)sulfat gelöst in 3,87 g Wasser, und 0,76 g Natriumperoxodisulfat zugegeben. Die Reaktionsmischung wurde anschließend weitere 3 h unter Kühlung von Außen mit Wasser mit einem Ultraschallfinger (Ultraschallprozessor der Fa. Hielscher UP 200 S24 khz, 100 W Leistung) beschallt. Die Reaktionstemperatur stieg in dieser Zeit von 20°C auf 35°C an. Nach Reaktionsende wurde die Dispersion durch Zugabe von 26 g Lewatit MP 62 (basischer Ionenaustauscher, Lanxess AG) und 45 g Lewatit S 100 (saurer Ionenaustauscher, Lanxewss AG) unter Rühren auf einem Magnetrührer ohne Ultraschall für 2 h entsalzt. Der Ionenaustauscher wurde dann über ein Filtertuch abfiltriert.

Die so erhaltene erfindungsgemäße PEDOT/PSS Dispersion hat einen Feststoffgehalt von 1,0 Gew.% und eine Viskosität von 7,9 mPas bei einer Scherrate von 100/sec (gemessen mit einem Rheometer bei 20°C).

### Bestimmung der Leitfähigkeit:

19 g dieser Dispersion wurde mit 1 g Dimethylsulfoxid versetzt. Ein gereinigtes Glassubstrat wurde auf eine Lackschleuder gelegt und 10 ml der oben genannten Mischungen wurden auf dem Substrat verteilt. Anschließend wurde die überstehende Lösung durch Rotation des Tellers abgeschleudert. Danach wurde das so beschichtete Substrat 15 min lang bei 130 °C auf einer Heizplatte getrocknet. Die Schichtdicke betrug 70 nm (Tencor, Alphastep 500).

Die Leitfähigkeit wurde bestimmt, indem über eine Schattenmaske Ag-Elektroden mit 2,5 cm Länge in einem Abstand von 10 mm aufgedampft werden. Der mit einem Elektrometer (Keithly 614) bestimmte Oberflächenwiderstand wurde mit der Schichtdicke multipliziert, um den elektrischen spezifischen Widerstand zu erhalten. Der spezifische Widerstand der Schicht lag bei 0,005747 Ohm·cm. Dies entspricht einer Leitfähigkeit von 174 S/cm. Die so hergestellten Schichten sind klar.

### Erfindungsgemäßes Beispiel 2:

In einem 2 1 Rührgefaß mit Kühlmantel, Rührer, Stickstoffein und -auslass, Flüssigkeits-ein und - auslass über Tauchrohre wurden 1389 g entionisiertes Wasser vorgelegt. Anschließend wurden 74,4 g einer 25 %igen wässrigen Polystyrolsulfonsäurelösung mit einem mittleren Molekulargewicht M_{w} von 70000 g /mol zugegeben. Die Lösung wurde unter Rühren durch Stickstoffeinleitung für 2 h sauerstofffrei gemacht. Nach Zugabe unter Stickstoff von 7,4 g 3,4 Ethylendioxythiophen wurde die Lösung unter Rühren 30 min. mit 10 l/h über eine Ultraschalldurchflußzelle der Fa. Dr. Hielscher GmbH, Stuttgart, Flow Cell D22K, Ultrasonic Processor UP400S gepumpt und mit einer Leistung von 400 W, 24 kHz beschallt. Anschließend wurden unter Stickstoff 0,14 g Eisen(III)-sulfat und 10,0 g Natriumperoxodisulfat gelöst in 80 g Wasser zugegeben. Die Lösung wurde weitere 3 h unter Rühren über die Ultraschalldurchflußzelle gepumpt und beschallt. Anschließend wurden 8,4 g Natriumperoxodisulfat gelöst in 80 g Wasser unter Stickstoff zugegeben und die Lösung weitere 8 h unter Rühren über die Ultraschalldurchflußzelle gepumpt und beschallt. Die Lösung wurde durch Kühlung von Außen während der gesamten Reaktionszeit bei 25°C gehalten.

Nach Abschluss der Reaktion wurde die Dispersion abgelassen und durch Zugabe von 172 g Lewatit MP 62 (basischer Ionenaustauscher, Lanxess AG) und 148 g Lewatit S 100 (saurer Ionenaustauscher, Lanxewss AG) unter Rühren auf einem Magnetrührer ohne Ultraschall für 2 h entsalzt. Der Ionenaustauscher wurde über ein Filtertuch abfiltriert.

Die so erhaltene erfindungsgemäße PEDOT/PSS Dispersion hat einen Feststoffgehalt von 1,35 % Gew.% und eine Viskosität von 55 mPas bei einer Scherrate von 100/sec (gemessen mit einem Rheometer bei 20°C). Die elektrische Leitfähigkeit wurde nach Zugabe von Dimethylsulfoxid wie oben beschrieben bestimmt und betrug 245 S/cm.

## Patentansprüche

1. Verfahren zur Herstellung einer wässrigen oder nicht-wässrigen Dispersion oder Lösung enthaltend wenigstens ein leitfähiges Polymer und wenigstens ein Polyanion, **dadurch gekennzeichnet, dass** die Polymerisation unter Ultraschall-Beschallung durchgeführt wird.

2. Verfahren nach Anspruch 1, wobei wenigstens ein Oxidationsmittel erst dann zugegeben wird, wenn unter Zuhilfenahme von Inertgas das Reaktionsmedium inertisiert ist.

3. Verfahren nach Anspruch 1, wobei die Polymerisation bei einem Druck durchgeführt wird, welcher unter dem Atmosphärendruck liegt.

4. Verfahren gemäß Anspruch 1, 2 oder 3, **dadurch gekennzeichnet, dass** wenigstens ein leitfähiges Polymer ein gegebenenfalls substituiertes Polypyrrol, ein gegebenenfalls substituiertes Polyanilin oder ein gegebenenfalls substituiertes Polythiophen ist.

5. Verfahren gemäß Anspruch 4, **dadurch gekennzeichnet, dass** wenigstens ein leitfähiges Polymer ein gegebenenfalls substituiertes Polythiophen enthaltend wiederkehrende Einheiten der allgemeinen Formel (I) 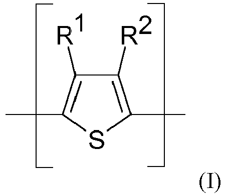 ist, wobei
R¹ und R² unabhängig voneinander jeweils für H, einen gegebenenfalls substituierten C₁-C₁₈-Alkylrest oder einen gegebenenfalls substituierten C₁-C₁₈-Alkoxyrest, oder
R¹ und R² zusammen für einen gegebenenfalls substituierten C₁-C₈-Alkylenrest, worin ein oder mehrere C-Atom(e) durch ein oder mehrere gleiche oder unterschiedliche Heteroatome ausgewählt aus O oder S ersetzt sein können, bevorzugt einen gegebenenfalls substituierten C₁-C₈-Oxythiaalkylenrest oder einen gegebenenfalls substituierten C₁-C₈-Dithiaalkylenrest, oder für einen gegebenenfalls substituierten C₁-C₈-Alkylidenrest, worin gegebenenfalls wenigstens ein C-Atom durch ein Heteroatom ausgewählt aus O oder S ersetzt sein kann, stehen.

6. Verfahren gemäß Anspruch 5, **dadurch gekennzeichnet, dass** wenigstens ein leitfähiges Polymer ein Polythiophen enthaltend wiederkehrende Einheiten der allgemeinen Formel (I-aaa) und/oder der allgemeinen Formel (I-aba) 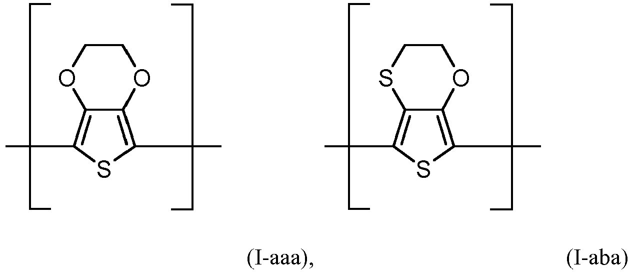 ist.

7. Verfahren gemäß Anspruch 6, **dadurch gekennzeichnet, dass** das Polyanion Polystyrolsulfonsäure ist.

8. Verfahren gemäß wenigstens einem der Ansprüche 1 bis 7, **dadurch gekennzeichnet, dass** zu der wässrigen oder nicht-wässrigen Dispersion leitfähigkeitssteigernde Mittel gegeben werden.

9. Verwendung einer wässrigen oder nicht-wässrigen Dispersion oder Lösung hergestellt nach wenigstens einem der Ansprüche 1 bis 8 zur Herstellung leitfähiger Beschichtungen, **dadurch gekennzeichnet, dass** die Leitfähigkeiten der so hergestellten Beschichtungen mindestens 150 S/cm betragen.

## Claims

1. Process for preparing an aqueous or nonaqueous dispersion or solution comprising at least one conductive polymer and at least one polyanion, **characterized in that** the polymerization is performed with ultrasound irradiation.

2. Process according to Claim 1, wherein at least one oxidizing agent is added only after the reaction medium has been inertized with the aid of inert gas.

3. Process according to Claim 1, wherein the polymerization is performed at a pressure below atmospheric pressure.

4. Process according to Claim 1, 2 or 3, **characterized in that** at least one conductive polymer is an optionally substituted polypyrrole, an optionally substituted polyaniline or an optionally substituted polythiophene.

5. Process according to Claim 4, **characterized in that** at least one conductive polymer is an optionally substituted polythiophene containing repeat units of the general formula (I) 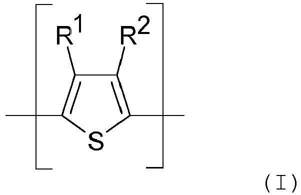 where
R¹ and R² are each independently H, an optionally substituted C₁-C₁₈-alkyl radical or an optionally substituted C₁-C₁₈-alkoxy radical, or
R¹ and R² together are an optionally substituted C₁-C₈-alkylene radical in which one or more carbon atoms may be replaced by one or more identical or different heteroatoms selected from 0 and S, preferably an optionally substituted C₁-C₈-oxythiaalkylene radical or an optionally substituted C₁-C₈-dithiaalkylene radical, or an optionally substituted C₁-C₈-alkylidene radical in which at least one carbon atom may optionally be replaced by a heteroatom selected from 0 and S.

6. Process according to Claim 5, **characterized in that** at least one conductive polymer is a polythiophene containing repeat units of the general formula (I-aaa) and/or of the general formula (I-aba)

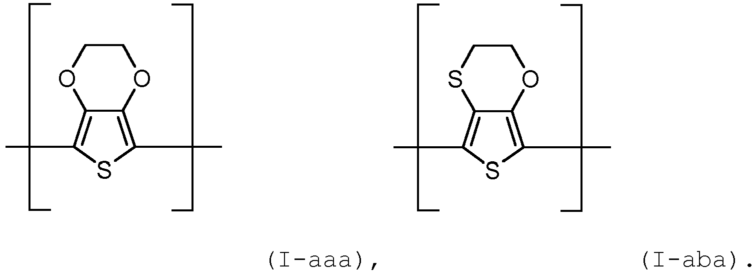

7. Process according to Claim 6, **characterized in that** the polyanion is polystyrenesulphonic acid.

8. Process according to at least one of Claims 1 to 7, **characterized in that** conductivity enhancers are added to the aqueous or nonaqueous dispersion.

9. Use of an aqueous or nonaqueous dispersion or solution prepared according to at least one of Claims 1 to 8 for producing conductive coatings, **characterized in that** the conductivities of the coatings thus produced are at least 150 S/cm.

## Revendications

1. Procédé de fabrication d'une dispersion ou d'une solution aqueuse ou non aqueuse contenant au moins un polymère conducteur et au moins un polyanion, **caractérisé en ce que** la polymérisation est réalisée sous exposition à des ultra-sons.

2. Procédé selon la revendication 1, dans lequel au moins un oxydant n'est ajouté que lorsque le milieu réactionnel est inertisé à l'aide d'un gaz inerte.

3. Procédé selon la revendication 1, dans lequel la polymérisation est réalisée à une pression qui est inférieure à la pression atmosphérique.

4. Procédé selon la revendication 1, 2 ou 3, **caractérisé en ce qu'**au moins un polymère conducteur est un polypyrrol éventuellement substitué, une polyaniline éventuellement substituée ou un polythiophène éventuellement substitué.

5. Procédé selon la revendication 4, **caractérisé en ce qu'**au moins un polymère conducteur est un polythiophène éventuellement substitué contenant des unités de répétition de formule générale (I) 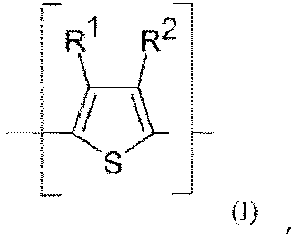 dans laquelle
R¹ et R² représentent chacun indépendamment l'un de l'autre H, un radical alkyle en C₁-C₁₈ éventuellement substitué ou un radical alcoxy en C₁-C₁₈ éventuellement substitué ou
R¹ et R² représentent ensemble un radical alkylène en C₁-C₈ éventuellement substitué, dans lequel un ou plusieurs atomes C peuvent être remplacés par un ou plusieurs hétéroatomes identiques ou différents choisis parmi 0 ou S, de préférence un radical oxythiaalkylène en C₁-C₈ éventuellement substitué ou un radical dithiaalkylène en C₁-C₈ éventuellement substitué ou un radical alkylidène en C₁-C₈ éventuellement substitué, dans lequel au moins un atome C peut éventuellement être remplacé par un hétéroatome choisi parmi 0 ou S.

6. Procédé selon la revendication 5, **caractérisé en ce qu'**au moins un polymère conducteur est un polythiophène contenant des unités de répétition de formule générale (I-aaa) et/ou de formule générale (I-aba)

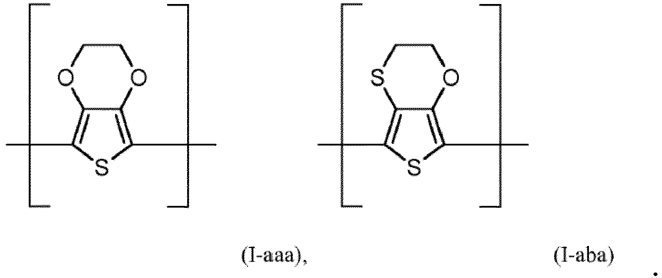

7. Procédé selon la revendication 6, **caractérisé en ce que** le polyanion est l'acide polystyrène-sulfonique.

8. Procédé selon au moins l'une quelconque des revendications 1 à 7, **caractérisé en ce que** des agents augmentant la conductivité sont ajoutés à la dispersion aqueuse ou non aqueuse.

9. Utilisation d'une dispersion ou d'une solution aqueuse ou non aqueuse fabriquée selon au moins l'une quelconque des revendications 1 à 8 pour la fabrication de revêtements conducteurs, **caractérisée en ce que** les conductivités des revêtements ainsi fabriqués sont d'au moins 150 S/cm.
